# EUROPÄISCHE PATENTSCHRIFT

(11) **EP 0 478 890 B1**
(45) Veröffentlichungstag und Bekanntmachung des Hinweises auf die Patenterteilung: **22.03.1995**
(21) Anmeldenummer: 91108315.2
(22) Anmeldetag: 23.05.1991
(51) Int. Cl.: H02H 7/20, H01S 3/096, H02H 9/00

(54) **Schutzschaltung für Laserdioden**
Protecting circuit for a laser diode
Circuit de protection pour diode laser

(30) Priorität: 02.10.1990 DE 4031066
(43) Veröffentlichungstag der Anmeldung: 08.04.1992
(73) Patentinhaber: ROBERT BOSCH GMBH, 70442 Stuttgart (DE)
(72) Erfinder: Wandel, Peter, W-1000 Berlin 42 (DE)

(56) Entgegenhaltungen:
- US-A- 4 924 473
- ELECTRONICS & WIRELESS WORLD, Bd. 93, Nr.1612, Februar 1987, GB, Seiten 167 - 169; J. VANDEWEGE ET AL.: 'Laser-diode power supply'
- PATENT ABSTRACTS OF JAPAN, vol. 12, no. 449 (E-686) 25. November 1988 & JP-A-63 177 491

## Beschreibung

Die Erfindung geht von einer Schutzschaltung nach dem Oberbegriff des Anspruchs 1 aus.

### Stand der Technik

Es ist eine derartige, als RF-Limiter bezeichnete Schutzschaltung bekannt, die eine Laserdiode zwar vor der Zerstörung durch einen einen vorgegebenen Wert überschreitenden Hochfrequenzpegel schützt, die aber verhältnismäßig kompliziert aufgebaut und teuer ist. Außerdem kann die bekannte Schutzschaltung nicht verhindern, daß die Laserdiode durch elektrostatische Aufladungen zerstört wird.

Aus der US-A-4 924 473 ist eine Laserdiodenschutzschaltung bekannt, die eine Laserdiode vor hohen Signalpegeln zuverlässig schützen soll, während die Schutzschaltung im Arbeitsbereich der Laserdiode eine sehr geringe Auswirkung auf die Funktion der Laserdiode ausübt. Bei hohen Signalpegeln wird daher durch die Laserdiodenschutzschaltung der Ansteuerstrom von der Laserdiode abgeschaltet.

### Aufgabe

Der Erfindung liegt die Aufgabe zugrunde, eine Schutzschaltung gemäß dem Oberbegriff des Anspruchs 1 derart weiterzubilden, daß sich der Herstellungsaufwand verringert. Außerdem soll die Schutzschaltung auch die Laserdiode vor elektrostatischen Aufladungen schützen.

### Lösung

Diese Aufgabe wird bei einer Schutzschaltung gemäß dem Oberbegriff des Anspruchs 1 durch die im Kennzeichen dieses Anspruchs aufgeführten Merkmale gelöst. Die mit der Erfindung erzielbaren Vorteile bestehen insbesondere darin, daß sich die Schutzschaltung einfach und kostengünstig herstellen läßt und daß sie nicht nur auf zu hohe Hochfrequenzpegel, sondern auch auf elektrostatische Aufladungen anspricht, die die Laserdiode zerstören könnten.

### Beschreibung

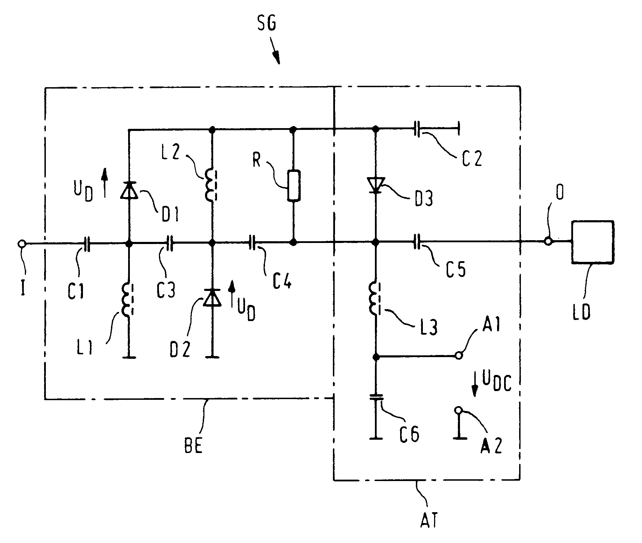

Ein Ausführungsbeispiel der Erfindung ist in der Zeichnung an Hand einer einzigen Figur dargestellt und wird im folgenden näher erläutert. Die Figur zeigt ein Schaltbild der erfindungsgemäßen Schutzschaltung.

In der Figur bezeichnet I den Hochfrequenzeingang der Schutzschaltung SG, die sich aus einer Hochfrequenzbegrenzungsschaltung BE und einer Hochfrequenzdämpfungsschaltung AT zusammensetzt. Der Eingang I steht erstens über einen ersten Kondensator C1 mit der Anode einer ersten Diode D1 und zweitens über eine erste Induktivität L1 mit Masse in Verbindung. Ein Schaltungspunkt zwischen der ersten Diode D1 und der ersten Induktivität L1 steht über einen dritten Kondensator C3 erstens mit einer zweiten Induktivität L2 und zweitens mit der Kathode einer zweiten Diode D2 in Verbindung. Ein Schaltungspunkt zwischen der zweiten Induktivität L2 und der zweiten Diode D2 steht über einen vierten Kondensator C4 erstens mit einem Widerstand R, zweitens mit der Kathode einer dritten Diode D3, drittens über einen fünften Kondensator C5 mit dem Ausgang O der Schutzschaltung SG und viertens über eine dritte Induktivität L3 und einen damit in Serie geschalteten sechsten Kondensator C6 mit Masse in Verbindung. Die den Kondensatoren C1, C3, C4, C5 abgewandten Enden der ersten Diode D1, der zweiten Induktivität L2, des Widerstandes R und der dritten Diode D3 sind gemeinsam über einen Kondensator C2 mit Masse verbunden. Ein erster Anschluß A1 ist mit einem Schaltungspunkt zwischen der dritten Induktivität L3 und dem sechsten Kondensator C6 verbunden, und ein zweiter Anschluß A2 liegt auf dem Massepotential. An die Anschlüsse A1 und A2 ist eine Gleichstromquelle der Spannung U_{DC} angeschlossen.

Die Wirkungsweise der vorstehend beschriebenen Schutzschaltung ist folgende.
1. Hochfrequenzbegrenzung
   1.1 Hat der Pegel des am Eingang I liegenden Hochfrequenzsignals einen zulässigen Wert nicht überschritten, dann werden die Dioden D1 und D2 der Hochfrequenzbegrenzungsschaltung BE über die dritte Induktivität L3, den Widerstand R und die erste Induktivität L1 bzw. die zweite Induktivität L2 mit der Gleichspannung U_{DC} in Sperrichtung vorgespannt. Damit sind die Dioden D1 und D2 sehr hochohmig. Die dritte Diode D3 ist stromlos und daher ebenfalls hochohmig. Der Weg für die Hochfreqenzsignale vom Eingang I zum Ausgang O der Schutzschaltung SG wird also durch die Dioden nicht beeinflußt.
   1.2 Überschreitet der Signalpegel am Eingang I den zulässigen Wert, dann werden die Dioden D1 und D2 in positiver bzw. negativer Richtung leitend, und der Pegel der Hochfrequenzsignale wird symmetrisch auf den zulässigen Wert begrenzt. Infolge der Begrenzung fließt ein Richtstrom über die Dioden D1 und D2 durch die dritte Diode D3, wodurch diese niederohmig gesteuert wird und das Hochfrequenzsignal zusätzlich dämpft. Der Wert der Gleichspannung U_{DC} bestimmt den Einsatzpunkt der Begrenzung.
2. Schutz vor elektrostatischer Entladung
   Die elektrostatische Entladung liegt in Form von positiven bzw. negativen Spannungsspitzen am Eingang I der Schutzschaltung SG. Dadurch werden die Dioden D1 und D2 in den leitenden Zustand gesteuert, so daß die Spannungsimpulse auf einen ungefährlichen Wert U_{DC} + U_{D} begrenzt werden. U_{D} ist der Spannungsabfall über der Diode D1 bzw. D2. Die dritte Diode D3 bleibt in diesem Fall stromlos, das heißt hochohmig.

Die erste und zweite Diode D1 und D2 sind vorzugsweise Schottky-Dioden, und die dritte Diode D3 ist vorzugsweise eine PIN-Diode. Als Induktivitäten L1 bis L3 eignen sich Ferritkernspulen. Mit den genannten Bauelementen läßt sich eine Schutzschaltung aufbauen, die für Hochfrequenzsignale eines Frequenzbereiches von etwa 30 MHz bis über 900 MHz geeignet ist. Durch die LC-Kombinationen L1, C1 und L2, C3 ist eine Hochpaßcharakteristik realisierbar, durch die die besonders energiereichen niederfrequenteren Anteile des Impulsspektrums herausgefiltert werden.

## Patentansprüche

1. Schutzschaltung zum Schutz einer Laserdiode vor Überlastung durch ein Eingangssignal, dessen Signalpegel einen vorgegebenen Wert überschreitet, dadurch gekennzeichnet, daß die Schutzschaltung (SG) eine Hochfrequenzbegrenzungsschaltung (BE) aufweist, die beim Überschreiten des vorgegebenen Werts eine Begrenzung des Eingangssignals bewirkt und daß die Schutzschaltung (SG) eine der Hochfrequenzbegrenzungsschaltung (BE) nachgeschaltete Hochfrequenzdämpfungsschaltung (AT) aufweist, die beim Überschreiten des vorgegebenen Werts gleichzeitig eine zusätzliche Dämpfung des begrenzten Eingangssignals bewirkt.

2. Schutzschaltung nach Anspruch 1, dadurch gekennzeichnet, daß die Hochfrequenzbegrenzungsschaltung (BE) eine erste und eine zweite Diode (D1, D2) enthält, die auf den Hochfrequenzeingang (I) bezogen gegensinnig gepolt und durch eine Gleichspannung (U_{DC}) in Sperrichtung vorgespannt sind, und daß die Hochfrequenzdämpfungsschaltung (AT) eine dritte Diode (D3) enthält, die ebenfalls durch die Gleichspannung (U_{DC}) in Sperrichtung vorgespannt ist.

3. Schutzschaltung nach Anspruch 1 oder 2, dadurch gekennzeichnet, daß die erste und zweite Diode (D1, D2) Schottky-Dioden sind.

4. Schutzschaltung nach einem der Ansprüche 1 bis 3, dadurch gekennzeichnet, daß die dritte Diode (D3) eine PIN-Diode ist.

5. Schutzschaltung nach Anspruch 1 oder einem der folgenden, dadurch gekennzeichnet, daß der Hochfrequenzeingang (I) der Schutzschaltung (SG) über einen ersten Kondensator (C1) erstens mit der Anode der ersten Diode (D1), zweitens über eine erste Induktivität (L1) mit Masse und drittens über einen dritten Kondensator (C3) erstens mit der Kathode einer zweiten Diode (D2), deren Anode auf dem Massepotential liegt, zweitens mit einer zweiten Induktivität (L2) und drittens über einen vierten Kondensator (C4) mit einem Widerstand (R) verbunden ist, daß ein Schaltungspunkt zwischen dem vierten Kondensator (C4) und dem Widerstand (R) erstens mit der Kathode der dritten Diode (D3), zweitens über eine dritte Induktivität (L3) und einen sechsten Kondensator (C6) mit Masse und drittens über einen fünften Kondensator (C5) mit dem Ausgang (O) der Schutzschaltung (SG) verbunden ist, daß die den Kondensatoren (C1, C3, C4 und C5) abgewandten Enden der ersten Diode (D1), der zweiten Induktivität (L2), des Widerstandes (R) und der dritter Diode (D3) über einen gemeinsamen zweiten Kondensator (C2) mit Masse verbunden sind und daß die Gleichspannung (U_{DC}) zwischen Masse und einem Schaltungspunkt zwischen der dritten Induktivität (L3) und dem sechsten Kondensator (C6) liegt.

## Claims

1. Protection circuit for the protection of a laser diode against overloading by an input signal whose signal level exceeds a predetermined value, characterized in that the protection circuit (SG) has a radio-frequency limiting circuit (BE) which limits the input signal if it exceeds the predetermined value, and in that the protection circuit (SG) has a radio-frequency attenuation circuit (AT) which is connected downstream of the radio-frequency limiting circuit (BE) and at the same time additionally attenuates the limited input signal when the predetermined value is exceeded.

2. Protection circuit according to Claim 1, characterized in that the radio-frequency limiting circuit (BE) contains a first diode (D1) and a second diode (D2) which are connected in opposite polarities with respect to the radio-frequency input (I) and are biassed in the reverse direction by means of a DC voltage (U_{DC}), and in that the radio-frequency attenuation circuit (AT) contains a third diode (D3) which is likewise biassed in the reverse direction by the DC voltage (U_{DC}).

3. Protection circuit according to Claim 1 or 2, characterized in that the first diode (D1) and the second diode (D2) are Schottky diodes.

4. Protection circuit according to one of Claims 1 to 3, characterized in that the third diode (D3) is a PIN diode.

5. Protection circuit according to Claim 1 or one of the following, characterized in that the radio-frequency input (I) of the protection circuit (SG) is connected via a first capacitor (C1) firstly to the anode of the first diode (D1), secondly via a first inductance (L1) to earth and thirdly via a third capacitor (C3) firstly to the cathode of a second diode (D2) whose anode is connected to earth potential, secondly to a second inductance (L2) and thirdly via a fourth capacitor (C4) to a resistor (R), in that a circuit point between the fourth capacitor (C4) and the resistor (R) is connected firstly to the cathode of the third diode (D3), secondly via a third inductance (L3) and a sixth capacitor (C6) to earth, and thirdly via a fifth capacitor (C5) to the output (O) of the protection circuit (SG), in that those ends of the first diode (D1), of the second inductance (L2), of the resistor (R) and of the third diode (D3) which face away from the capacitors (C1, C3, C4 and C5) are connected via a common second capacitor (C2) to earth, and in that the DC voltage (U_{DC}) is connected between earth and a circuit point between the third inductance (L3) and the sixth capacitor (C6).

## Revendications

1. Circuit de protection d'une diode laser contre la surcharge par un signal d'entrée dont le niveau dépasse une valeur prédéterminée, caractérisé en ce que le circuit de protection (SG) comprend un circuit de limitation haute fréquence (BE) qui, en cas de dépassement de la valeur prédéterminée, assure la limitation du signal d'entrée, et le circuit de protection (SG) comporte un circuit d'amortissement de fréquence (AT) en aval du circuit de limitation haute-fréquence (BE), et lors du dépassement de la valeur prédéterminée ce circuit (AT) assure en même temps un amortissement supplémentaire du signal d'entrée, limité.

2. Circuit de protection selon la revendication 1, caractérisé en ce que le circuit de limitation haute fréquence (BE) se compose d'une première et d'une seconde diodes (D1, D2) polarisées en sens opposé par rapport à l'entrée haute fréquence (I) et dans le sens bloquant, par une tension continue (U_{DC}) et le circuit d'amortissement haute-fréquence (AT) comporte une troisième diode (D3) également polarisée dans le sens bloquant par la tension continue (U_{DC}).

3. Circuit de protection selon la revendication 1 ou 2, caractérisé en ce que la première et la seconde diode (D1, D2) sont des diodes Schottky.

4. Circuit de protection selon l'une des revendications 1 à 3, caractérisé en ce que la troisième diode (D3) est une diode PIN.

5. Circuit de protection selon la revendication 1 ou l'une des revendications suivantes, caractérisé en ce que l'entrée haute fréquence (I) du circuit de protection (SG) est reliée par un premier condensateur (C1) d'une part à l'anode de la première diode (D1) et d'autre part par une première inductance (L1), à la masse et en troisième part, à l'aide d'un troisième condensateur (C3), à la fois à la cathode d'une seconde diode (D2) dont l'anode est à la masse et à une seconde inductance (L2) et en troisième part, à l'aide d'un quatrième condensateur (C4) à une résistance (R), le point du circuit entre le quatrième condensateur (C4) et la résistance (R) étant d'une part reliée à la cathode de la troisième diode (D3), en second lieu par une troisième inductance (L3) et un sixième condensateur (C6) à la masse, et en troisième lieu par un cinquième condensateur (C5) à la sortie (0) du circuit de protection (SG), les extrémités de la première diode (D1), de la seconde inductance (L2), de la résistance (R) et de la troisième diode D3, opposées aux condensateurs (C1, C3, C4, C5) étant reliés par un second condensateur commun, (C2) à la masse, et la tension continue (U_{DC}) est appliquée entre la masse et un point du circuit entre la troisième inductance (L3) et le sixième condensateur (C6).
